# EUROPEAN PATENT SPECIFICATION

(11) **EP 0 503 077 B1**
(45) Date of publication and mention of the grant of the patent: **08.01.1997**
(21) Application number: 91916782.5
(22) Date of filing: 26.09.1991
(51) Int. Cl.: H01L 27/115

(54) **SEMICONDUCTOR DEVICE**
HALBLEITERBAUELEMENT
DISPOSITIF A SEMI-CONDUCTEURS

(30) Priority: 28.09.1990 JP 259456/90
(43) Date of publication of application: 16.09.1992
(73) Proprietor: RAMTRON INTERNATIONAL CORPORATION, Colorado Springs, Colorado 80921 (US)
(72) Inventor: TAKENAKA, Kazuhiro, Suwa-shi, Nagano-ken 392 (JP)
(74) Representative: Quinterno, Giuseppe
(86) International application number: JP9101281
(87) International publication number: WO9206499

(56) References cited:
- EP-A- 0 380 326
- EP-A- 0 478 799
- JP-A- 2 183 569
- JP-A- 2 183 570
- JP-A- 2 232 973
- IBM TECHNICAL DISCLOSURE BULLETIN. vol. 31, no. 9, February 1989, NEW YORK US
- pages 249 - 251; 'Structure for improving the electrical characteristics of polysilicon contacted n-p junction'

## Description

The present invention relates to a semiconductor device, such as a memory structure, using a ferroelectric material, and more particularly, a nonvolatile memory capable of electric re-writing.

### BACKGROUND OF THE INVENTION

MIS transistors are usually used for conventional semiconductor nonvolatile memories. These memories use a phenomenon where the surface potential of a silicon substrate can be modified through an injection of charge from the silicon substrate into an insulating gate trap or a floating gate. Examples of these memories are an EPROM (ultra-violet ray erasing type nonvolatile memory) and an EEPROM (electrically rewritable nonvolatile memory).

These nonvolatile memories, however, have disadvantages in that the information re-writing voltage is usually high (about 20 V), and the re-writing time is extremely long (several tens of msec. for the EEPROM). In addition, the information re-writing number is very small, typically about 10,000, thus posing problems for repeated use.

With a nonvolatile memory using a ferroelectric material capable of an electrically inverting polarization, the writing-in and reading-out times are substantially the same in principle, and the polarization is maintained even if the power source is disconnected. Thus, the memory can possibly be an ideal nonvolatile memory. Proposals for such a nonvolatile memory using a ferroelectric material include structures having a ferroelectric capacitor integrated on a silicon substrate as shown in United States Patent No. 4,149,302, and a ferroelectric film provided on a gate portion of a MIS transistor as shown in United States Patent No. 3,832,700.

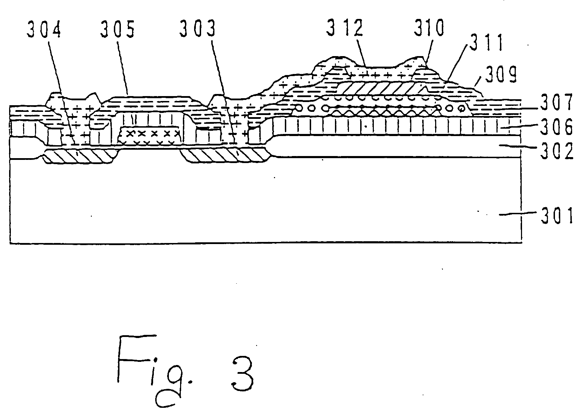

Further, a non-volatile memory having a laminated structure of a MOS semiconductor device as shown in figure 3 has been recently proposed in the IEDM, '87 pp, 850-851. In figure 3, 301 designates a P-type Si substrate, 302 designates a LOCOS oxide film for isolation, 303 designates an N-type diffusion layer constituting a source, 304 designates an N-type diffusion layer constituting a drain, 305 designates a gate electrode, and 306 designates an interlayer insulating film. Designated by 309 is a ferroelectric film which forms a capacitor with upper and lower electrodes 310 and 311 having the ferroelectric film therebetween. 307 illustrates a second interlayer insulating, and 312 designates an Al lead, wiring or interconnection electrode which connects the upper electrode 310 to the source diffusion layer 303.

In such a ferroelectric memory, the upper electrode 310 is formed by using Pt and the like in view of its contact with the ferroelectric film 309. The wiring or interconnection is carried out by using the wiring electrode 312. With such a structure, the cell area is increased, and a high density integration is not attained. The present invention seeks to solve this problem, and its object is to provide a ferroelectric memory which has a reduced memory cell area and is suitable for integration.

European Patent Application EP-A-0 478 799, cited pursuant to Art.54(3) EPC, discloses a semiconductor memory device having drain and source regions, a gate electrode and a ferroelectric capacitor. The capacitor comprises a ferroelectric film sandwiched between a lower electrode and an upper electrode. The upper electrode is of aluminum and is connected to the source region.

European patent application EP-A-0 380 326 discloses a ferroelectric semiconductor structure having a substrate with drain and source regions therein and a gate electrode located between the drain and source regions. The ferroelectric capacitor is formed over the drain region and gate electrode. The bottom or lower electrode is formed over an interlayer insulating film and is coupled directly to the source region through a contact hole in the insulating film. A ferroelectric film is formed over the lower electrode, and an upper or top electrode is then formed over the ferroelectric film.

IBM Technical Disclosure Bulletin, vol.31, No.9, February 1989, pages 249-251, discloses a shallow n-p junction of a bipolar transistor. The junction has a layer of polysilicon in a contact hole of a silicon oxide. A layer of a conducting oxide is on top of the polysilicon, and a layer of a metal is on top of the conducting oxide. A layer of polysilicon is provided in the contact hole.

Patent Abstracts of Japan, 149 E 985 and JP-A-2 183 569 relate to a MOS type FET device, comprising a ferroelectric capacitor formed with Al electrodes and a PZT ferromaqnetic dielectric. To avoid oxygen suction from the ferroelectric substance film, two layers of TiN are formed between the Al electrodes and the dielectric.

### SUMMARY OF THE INVENTION

The present invention aims at providing an improved semiconductor device having a ferroelectric capacitor integrated in a substrate, suitable for use as a structure of unit cell forming a part of a memory. This aim or object is achieved according to the invention by a semiconductor device having the features defined in claim 1.

### BRIEF DESCRIPTION OF THE DRAWINGS

Fig. 1 is a sectional view showing an example useful for understanding the present invention;
Fig. 2 is a sectional view showing an embodiment of the present invention; and
Fig. 3 is a sectional view showing a conventional semiconductor memory using a ferroelectric material.

### DETAILED DESCRIPTION OF THE PREFERRED EMBODIMENTS

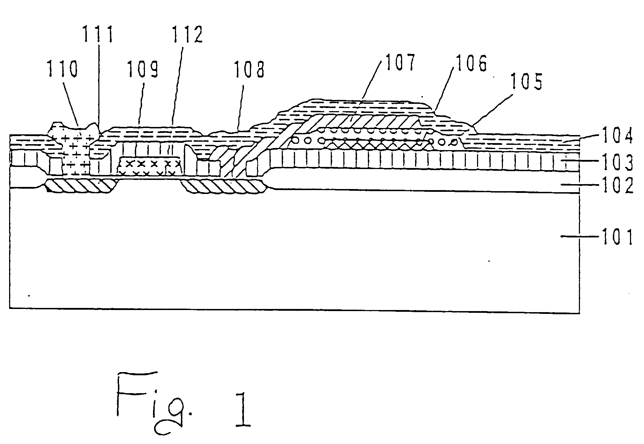

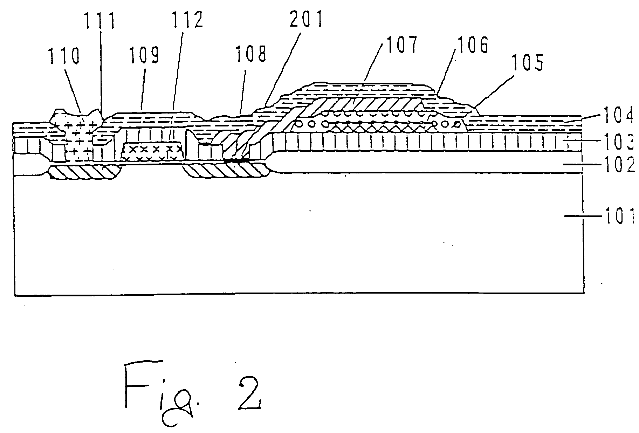

The present invention will be described with reference to Figs. 1 and 2. In the description, a Si substrate and an N-channel transistor are used as an example. A P-channel transistor could be used in a similar manner.

101 illustrates a P-type Si substrate formed by using, for example, a wafer with a specific resistance of 20 Ohm.cm. 102 indicates a SiO₂ film for isolation, which is formed to a thickness of 6000 Å (IÅ = 0.1 nm) by using a conventional LOCOS technique. 109 indicates, for example, poly-Si intended to form a gate electrode which is grown to a thickness of 5,000 Å using a vapor phase epitaxy, that is a chemical vapor deposition method. 112 indicates SiO₂ gate insulation film formed to a thickness of 300 Å. 103 indicates an interlayer insulation film for separating the gate electrode 109 and a ferroelectric film 105. The interlayer insulation film is formed of, for example, SiO₂ with a thickness of 4000 Å.

106 indicates a lower electrode of a ferroelectric capacitor. The electrode is formed, for example, of Pt with a thickness of 2000 Å. 105 illustrates the ferroelectric film which is formed of, for example, PZT with a thickness of 6000 Å by using a sputtering method. 108 indicates an N-type diffusion layer intended to form a source of a MOS transistor which is formed MOS transistor by using, for example, an ion injection of phosphorus at a dosage of 5x10¹⁵/cm². 111 indicates an N-type diffusion layer intended to form a drain of the MOS transistor which is connected with an interconnecting or wiring electrode 110, made of, for example, Al.

107 designates an upper electrode formed by a sputtering of Pt to a thickness of 2000 Å. The upper electrode 107 also plays the role of connection wiring between the upper electrode 107 and the source diffusion layer 108. 104 indicates an interlayer insulation film for isolating the ferroelectric capacitor and the wiring electrode 110 of Al. The interlayer insulation film 104 is formed by, for example, growing SiO₂ to a thickness of 5000 Å.

The operation according to this invention is described below. Since 107 is the upper electrode of the ferroelectric film, a metal having a high melting point such as Pt and the like is required. The ferroelectric capacitor is located close to the source diffusion layer 108, so that it is possible to connect the upper electrode 107 of the ferroelectric capacitor to the source diffusion layer 108 by using the upper electrode 107 as it is. Thus, the area of an element may be made smaller and, therefore, a memory suitable for integration is obtainable. Further, the wiring electrode 110 can be formed in the upper part of 107 (not shown), so that the freedom of wiring is increased.

Fig. 2 is a sectional view showing an embodiment of this invention. In Fig. 2, a barrier metal 201 is made of, for example, TiN and is located between the upper electrode 107 and the source diffusion layer 108. Usually, a metal having such a high melting point such as Pt and the like has a strong reaction with respect to Si. The reaction of the metal occurs during a thermal treatment after the formation of the upper electrode 107, which sometimes causes a short circuit between the source diffusion layer 108 and the P-type substrate 101. In order to prevent this reaction, a barrier metal 201 is provided in the structure shown in Fig. 2. The barrier metal 201 may be TiN formed by using a sputtering method, or TiON, MoSi, TiW, RuO₂, ReO₂ and so forth. After forming these barrier metals over the entire wafer surface by using a sputtering method, for example, the steps of coating a resist and then etching back are carried out, thus obtaining the structure shown in Fig. 2.

As described above, according to this invention, a memory suitable for integration is obtained by taking a memory structure where at least one capacitor with a ferroelectric material is integrated on the substrate of the semiconductor device, and especially in the structure of a unit cell forming the memory, the upper electrode of the capacitor is directly connected through a conductive barrier film to the high density diffusion layer which constitutes a part of the MOS transistor.

## Claims

1. A semiconductor device comprising:
a transistor (108, 109, 111) having a gate electrode (109) located above a substrate (101), and source (108) and drain (111) electrodes located in the substrate (101), the transistor (108, 109,111) being associated with electrical insulation (103) having a contact window therein to said source electrode (108);
a ferroelectric capacitor (106, 105, 107) located above the substrate (101) and having a lower electrode (106), a dielectric (105) including a ferroelectric material which is located over said lower electrode (106); and an upper electrode (107) having first and second portions, said dielectric (105) being located between said first portion and said substrate (101), said second portion extending into said contact window for said source electrode (108), said upper electrode (107) being comprised of a metal having a high melting point; and
a conductive barrier film (201) disposed within said contact window between said upper electrode second portion and said source electrode (108).

2. The device of Claim 1 wherein said conductive barrier film (201) is a compound selected from the group comprising TiN, MoSi, TiW, RuO₂ and ReO₂.

3. The device of Claim 1 wherein said ferroelectric material is comprised of lead zirconate titanate.

4. The device of Claim 1 wherein said upper and lower electrodes (107, 106) are comprised of platinum.

## Patentansprüche

1. Halbleitervorrichtung, mit
einem Transistor (108, 109, 111) mit einer Gate-Elektrode (109) über einem Substrat (101) und mit Source- (108) und Drain- (111) -Elektroden im Substrat (101), wobei der Transistor (108, 109, 111) mit einer elektrischen Isolierung (103) mit einem Kontaktfenster zur Source-Elektrode (108) versehen ist; mit
einem ferroelektrischen Kondensator (106, 105, 107) über dem Substrat (101) mit einer unteren Elektrode (106), einem Dielektrikum (105) mit einem ferroelektrischen Material, das sich über der unteren Elektrode (106) befindet; und mit einer oberen Elektrode (107) mit einem ersten und einem zweiten Abschnitt, wobei sich das Dielektrikum (105) zwischen dem ersten Abschnitt und dem Substrat (101) befindet, sich der zweite Abschnitt in das Kontaktfenster für die Source-Elektrode (108) hinein erstreckt und die obere Elektrode (107) aus einem Metall mit einem hohen Schmelzpunkt ist; und mit
einer leitenden Barriereschicht (201), die im Kontaktfenster zwischen dem zweiten Abschnitt der oberen Elektrode und der Source-Elektrode (108) angeordnet ist.

2. Vorrichtung nach Anspruch 1, wobei die leitende Barriereschicht (201) eine Verbindung aus einer Gruppe ist, die TiN, MoSi, TiW, RuO₂ und ReO₂ umfaßt.

3. Vorrichtung nach Anspruch 1, wobei das ferroelektrische Material aus Elei, Zirkonat und Titanat besteht.

4. Vorrichtung nach Anspruch 1, wobei die obere und die untere Elektrode (107, 106) aus Platin bestehen.

## Revendications

1. Dispositif à semi-conducteur comprenant :
un transistor (108, 109, 111) ayant une électrode de grille (109) disposée au-dessus d'un substrat (101), une électrode de source (108) et une électrode collectrice (111) disposées dans le substrat (101), le transistor (108, 109, 111) étant associé à un isolant électrique (103) dans lequel est formée une fenêtre de contact en vis-à-vis de ladite électrode de source (108) ;
un condensateur ferroélectrique (106, 105, 107) disposé au-dessus du substrat (101) et ayant une électrode inférieure (106), un diélectrique (105) comprenant un matériau ferroélectrique qui est disposé sur ladite électrode inférieure (106) ; et une électrode supérieure (107) ayant une première et une seconde parties, ledit diélectrique (105) étant disposé entre ladite première partie et ledit substrat (101), ladite seconde partie se prolongeant dans ladite fenêtre de contact prévue pour l'électrode de source (108), ladite électrode supérieure (107) étant constituée d'un métal ayant un point de fusion élevé ; et
un film d'arrêt conducteur (201) disposé à l'intérieur de ladite fenêtre de contact entre ladite seconde partie de l'électrode supérieure et ladite électrode de source (108).

2. Dispositif selon la revendication 1, dans lequel ledit film d'arrêt conducteur (201) est un composé choisi dans le groupe comprenant TiN, MoSi, TiW, RuO₂ et ReO₂.

3. Dispositif selon la revendication 1, dans lequel ledit matériau ferroélectrique est constitué de titanate et zirconate de plomb.

4. Dispositif selon la revendication 1, dans lequel lesdites électrodes supérieure et inférieure (107, 106) sont constituées de platine.
